(19) **Europäisches Patentamt**

**European Patent Office**

**Office européen des brevets**

(11) **EP 1 018 028 B1**

(12) **EUROPEAN PATENT SPECIFICATION**

(45) Date of publication and mention
of the grant of the patent:
**04.08.2004 Bulletin 2004/32**

(51) Int Cl.⁷: **G01R 31/12**, H02H 7/04

(21) Application number: **97909788.8**

(86) International application number:
**PCT/SE1997/001678**

(22) Date of filing: **08.10.1997**

(87) International publication number:
**WO 1998/016841 (23.04.1998 Gazette 1998/16)**

(54) **A DEVICE FOR MONITORING PARTIAL DISCHARGES IN AN ELECTRIC HIGH-VOLTAGE APPARATUS OR HIGH-VOLTAGE EQUIPMENT**

EIN GERÄT ZUR ÜBERWACHUNG TEILWEISER ENTLADUNGEN IN EINEM GERÄT MIT ELEKTRISCHER HOCHSPANNUNG ODER IN EINER HOCHSPANNUNGSANLAGE

DISPOSITIF POUR SURVEILLER LES DECHARGES PARTIELLES DANS UN APPAREIL ELECTRIQUE A HAUTE TENSION OU DU MATERIEL A HAUTE TENSION

(84) Designated Contracting States:
**AT CH DE ES FR GB IT LI**

(30) Priority: **16.10.1996 SE 9603798**

(43) Date of publication of application:
**12.07.2000 Bulletin 2000/28**

(73) Proprietor: **ABB Research Ltd.**
**721 78 Västeras (SE)**

(72) Inventors:
• **JOHANSSON, Kenneth**
**S-722 28 Västeras (SE)**
• **KOLS, Hakan**
**S-723 44 Västeras (SE)**

(74) Representative: **Dahlstrand, Björn et al**
**ABB AB**
**Legal Affairs and Compliance /**
**Intellectual Property**
**721 78 Västeras (SE)**

(56) References cited:
**WO-A-96/35128**     **DE-A- 3 601 934**
**DE-A- 4 124 268**     **US-A- 4 897 607**

## Description

TECHNICAL FIELD

The present invention relates to a device for monitoring partial discharges in such electric high-voltage equipment or high-voltage apparatus, for example a high-voltage transformer, which has a high-voltage bushing with a capacitive test tap. The device comprises an inductive current transducer in the form of a measuring coil arranged around the high-voltage bushing, and signal-processing members adapted, for detection of partial discharges, to be supplied with signals from the inductive current transducer and from the capacitive test tap.

BACKGROUND ART

From the older Swedish patent application 9501664-8, which corresponds to the international patent application PCT/SE96/00558 (WO9635128) a device and a method for monitoring partial discharges in an electric power transformer are previously known. The transformer has a high-voltage bushing with a capacitive test tap, from which a measurement signal is obtained which is a measure of the electric field at the bushing. An inductive transducer in the form of a coil system, arranged around the bushing, delivers a measurement signal corresponding to the current through the bushing. The two measurement signals are supplied to signal-processing members. In these, the signals are multiplied by each other, which makes it possible to distinguish internal discharges from external disturbances or other signals. Further, the signal-processing members comprise means for closer analysis of the measurement signals, for example for determining the level of the internal partial discharge and for triggering an alarm signal if the level exceeds a predetermined alarm level.

It has proved that this known device has certain disadvantages. Thus, the sensitivity of the device to internal discharges varies with the working conditions of the transformer, and under certain circumstances the sensitivity is annoyingly low. Further, the sensitivity to internal discharges, that is, the discharges which are of interest, is always lower than the sensitivity to external discharges or other external disturbances, which is an obvious disadvantage. The difference in sensitivity to external and internal discharges also makes the calibration of the device difficult.

In the known device, the two measurement signals originate from transducers of different types - one capacitive test tap and one inductive measuring coil. Since the signals during the signal processing are multiplied by each other, they must have the same phase occurrence. To achieve this, the input circuits of the signal-processing members for the two measurement signals must be different, and further, individual adjustment of the input stages in dependence on, inter alia, cable length and type of bushing is required.

The galvanic connection from the capacitive test tap to the signal-processing members further entails a not insignificant risk of the latter being subjected to overvoltages or other disturbances, for example in case of lightning strokes or other disturbances on the network to which the transformer is connected.

In the known device, the current from the capacitive test tap must pass back and further through the cable and the contact means which couple the test tap with the signal-processing members, and in the latter through that impedance network in the form of resistors, capacitors and inductors which is included in the matching circuits of the input stages. This involves a not insignificant risk of interruption in the circuit, which in turn entails a risk of damage to the bushing.

SUMMARY OF THE INVENTION

It is an object of the invention to provide a device of the kind stated in the introduction, which, compared with prior art devices of the relevant kind, has increased sensitivity for detection of internal partial discharges and at the same time a reduced sensitivity to external partial discharges or other disturbances.

Another object of the invention is to provide a device in which, to make possible a simple and accurate calibration, the sensitivity can be made similar for both internal and external discharges.

A further object of the invention is to provide a device in which the input stages of the signal-processing members may be designed identical, and in which the need of individual adjustment is eliminated.

A still further object of the invention is to provide a device which offers greater operating and personal safety and exhibits less sensitivity to disturbance than the prior art device.

What characterizes a device according to the invention will become clear from the appended claims.

BRIEF DESCRIPTION OF THE DRAWINGS

The invention will be explained in more detail in the following with reference to the accompanying Figures 1-5, wherein

Figure 1 shows a prior art device of the kind described above, wherein Figure 1a schematically shows the construction of the device and its connection to a power transformer, wherein Figure 1b illustrates the funcion in case of an internal discharge, and wherein Figure 1c shows the function in case of an external discharge,

Figure 2 shows the principle for a simple embodiment of a device according to the invention,

Figure 3 shows an embodiment of the invention with current-distributing members which distribute the current from the capacitive test tap between two current paths, one of which runs outside the measuring coil and one of which traverses the coil,

Figure 4 shows a variant of the embodiment shown in Figure 3, wherein the two terminals of the capacitive test tap are used for coupling of the measuring conductors from the test tap,

Figure 5 shows a preferred embodiment wherein the current-dividing member is constituted of a first current transformer, and wherein a second current transforme is adapted for measurement of the current from the capacitive test tap.

## DESCRIPTION OF THE PREFERRED EMBODIMENTS

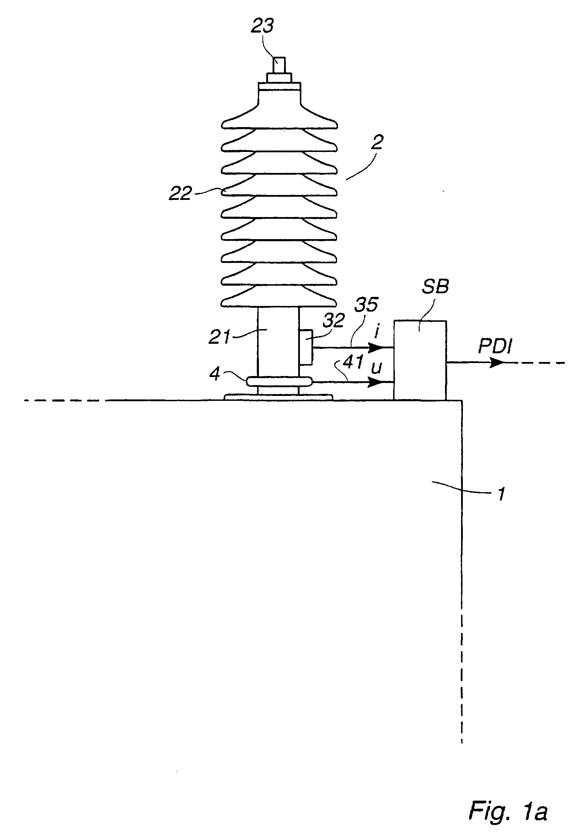

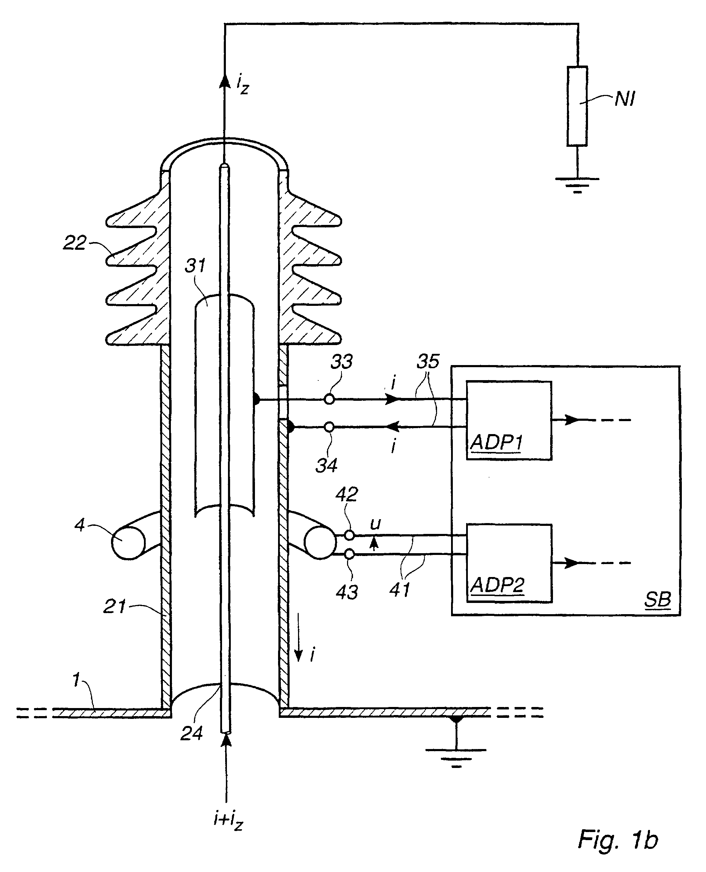

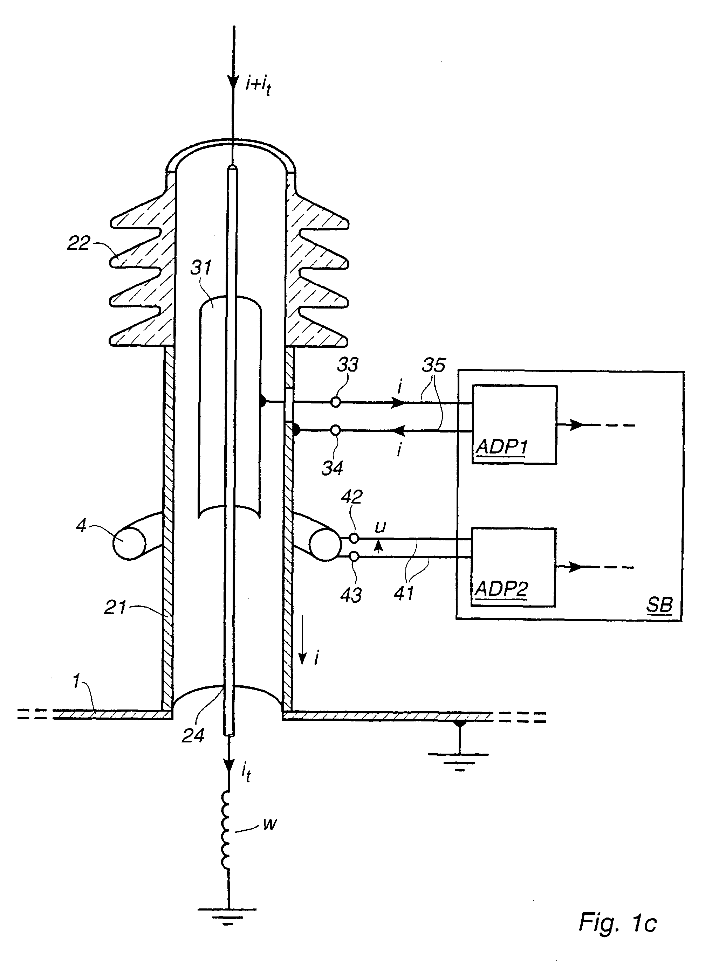

Figure 1a shows a prior art device, known from the above-mentioned older patent application, for monitoring partial discharges in an electric power transformer. The figure schematically shows a transformer 1 with a bushing 2. The bushing has a metal pipe 21 which is attached to the casing of the transformer. The pipe 21 supports an insulator 22, in which the conductor 24 (see Fig. 1b) of the bushing is arranged and connected to the electrical connection 23 of the bushing. The bushing has a conventional capacitive test tap with a connection box 32. From the test tap (in case of a change of the voltage on the conductor of the bushing), a measurement signal is delivered in the form of a current "i". Around the lower part of the bushing, a measuring coil 4 is applied, and from this a measurement signal "u" is obtained (in case of a change of the current in the conductor of the bushing). The measurement signals are supplied to a signal-processing member SB via cables 35, 41 (e.g. coaxial cables).

Both the measuring coil 4 and the signal-processing member SB are suitably designed in the manner described in the above-mentioned patent application. Thus, the measuring coil is preferably a whole or divided Rogowski coil, and the signal-processing members are suitably adapted (after necessary matching, filtering, amplification, etc.) to multiply the two measurement signals, which makes possible a determination of whether a detected partial discharge originates from inside the transformer or is caused by an external discharge or other external disturbance. From the signal-processing member SB, a signal PDI is obtained which is a measure of the level or intensity of internal partial discharges in the transformer. In the manner described in the previous patent application, this signal may be supplied to a data-collection system for monitoring the transformer, for example for triggering an alarm if the discharge level exceeds a predetermined limit value, or for analysis of the condition and function of the transformer in dependence on the detected discharges.

Figure 1b schematically shows a section through the bushing in the device according to Figure 1a. The casing of the transformer 1 is shown connected to ground in the figure, and the potential of the transformer casing will hereinafter be designated "ground" although, in certain cases, the transformer may be erected on a potential deviating from ground. Via the conductor 24 of the bushing, the transformer is connected to a network, symbolically shown as an impedance element NI which corresponds to the impedance of the network, as viewed from the transformer.

The bushing has a schematically shown capacitive test tap with two connection terminals 33 and 34. The terminal 33 is coupled to a capacitor layer 31 arranged in the bushing, and the terminal 34 is coupled to the metal pipe 21, that is, to ground potential. The two terminals are coupled to the cable 35.

The measuring coil 4 is only shown schematically in the figure with its connection terminals 42 and 43, to which the cable 41 is coupled.

The measurement signals "i" and "u" are supplied to matching circuits ADP1 and ADP2 via the cables 35 and 41. The matching circuits are part of the input stage of the signal-processing member SB and comprise impedance networks with passive circuit elements in the form of resistors, capacitors and inductance elements for impedance matching of the inputs of the signal-processing member, and possibly also for matching of the levels of the signals to each other. The output signals of the matching circuits are forwarded to other circuits (not shown in the figure), included in the signal-processing member, for filtering, amplification, multiplication, etc.

Figure 1b illustrates the function of the device in the case of an internal partial discharge. The discharge is assumed to be caused by a positive current out through the conductor 24. One part of the current, "i", is coupled to ground via the capacitive test tap, and another part, "iz", is coupled to ground via the network coupled to the transformer, for example via line capacitances, surge arrestes and load objects. The total current caused by the discharge is thus i + iz. However, the current "i" flows both back and forth through the measuring coil - up through the conductor 24 and down through the pipe 21 - and does not give rise to any net current through the coil. The only current which the coil measures is thus $i_z$. The measurement signal will therefore be dependent on the impedance of the load of the transformer. During high-voltage testing, for example, a load is not always connected, and the current sensed by the coil thus becomes low and the sensitivity of detection of the device poor.

Figure 1c shows the function of the device in the case of an external partial discharge. In this case, there pass through the measuring coil both the current "it" which flows to ground via the transformer winding W and the current "i" which flows to ground via the capacitive test tap. Thus, the coil measures the current $i + i_t$.

The above facts contribute to give the device higher sensitivity to external discharges and hence also to external disturbances. On the other hand, the sensitivity is low to internal discharges, which is the very phenomenon that is desired to detect. Further, the different sensitivities to internal and external discharges, as well as the sensitivity to internal discharges which varies with the load impedance, render the calibration of the device difficult.

As mentioned above, it is required that the two measuring channels exhibit the same phase characteristic, which requires that, for example, the input stage for the signal from the capacitive test tap modifies this measurement signal such that its characteristic as far as possible becomes the same as the signal from the measuring coil. Further, it has proved that an individual adjustment of at least one input stage is required in connection with installation of the device, which is due, among other things, to variations in cable length and to the type of bushing being used.

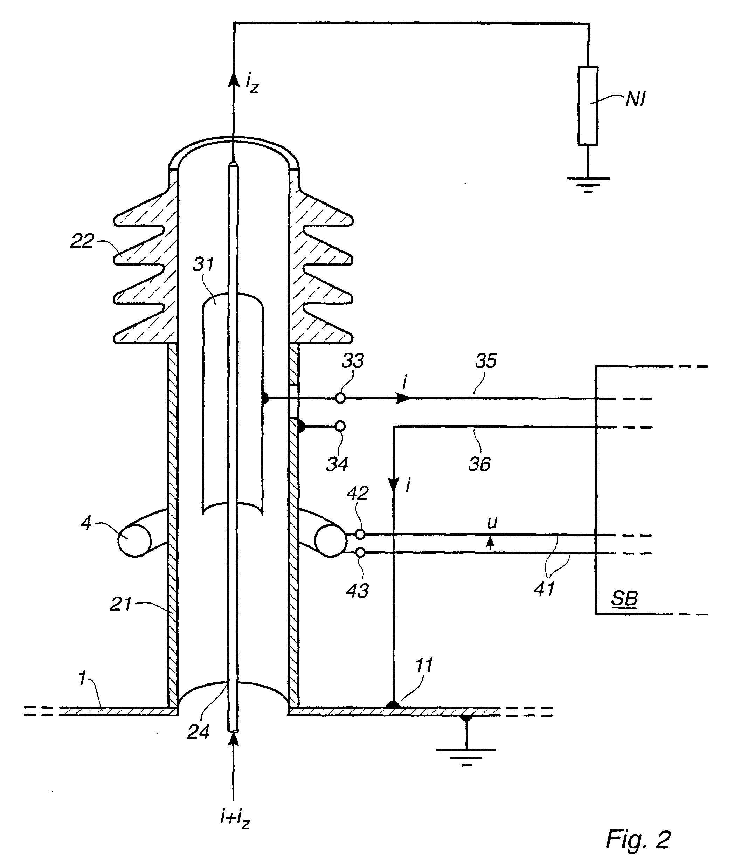

Figure 2 shows one embodiment of the invention. In this embodiment, the current-carrying return conductor 36 from the signal-processing member SB is not, as in the previously known device, coupled to the ground terminal 34 of the test tap but instead extended past - outside - the coil 4 to a ground connection 11 on the transformer casing. The conductors 24, 35 and 36 thus form a current coil around the coil for discharge signals originating from inside the transformer, which results in these signals in their entirety being detected by the coil.

The figure shows the case with an internal partial discharge. As is clear from the figure, the coil will detect the whole current $i + iz$. The sensitivity to such discharges will thus be good and its dependence on the load impedance of the transformer is considerably reduced. For an external discharge, on the other hand, only the current $i_t$ is detected (cf. Fig. 1c). The sensitivity to such discharges, as well as to external disturbances, is thus considerably reduced compared with the known device, which involves an additional advantage.

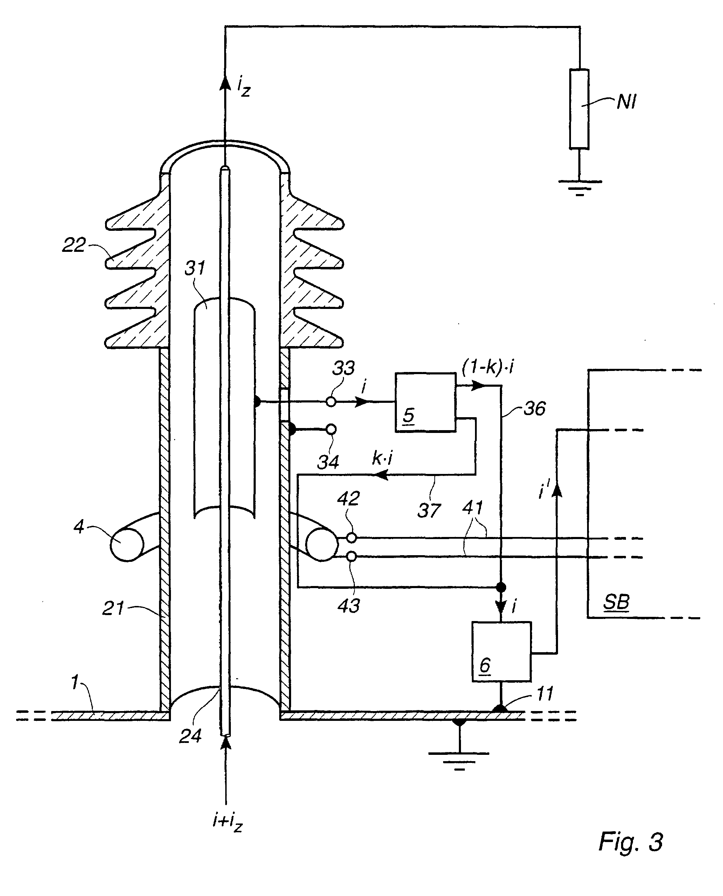

If the measuring coil 4 were ideal, the current flowing through the conductor 36 would not at all cause any induced voltage in the coil. In practice, there is a risk of this current giving rise to a certain induced voltage in the coil. Under certain circumstances, this may mean that an external discharge or disturbance gives rise to a measurement signal from the coil with such a polarity that the device incorrectly detects the signals as originating from an internal discharge. According to the improvement of the invention shown in Figure 3, there is therefore arranged, in addition to the current path 36 arranged outside the measuring coil, also a second current path 37 traversing the coil. Further, there is arranged a current-distributing member 5, which distributes the current "i" from the test tap between the two current paths. The current distribution is made in such a way that one current $k \cdot i$ flows through the conductor 37 and one current $(1-k) \cdot i$ through the conductor 36. The conductors 36 and 37 are connected together after the passage of the conductor 37 through the measuring coil and the current "i" is thereafter passed via a current-measuring device 6 to the ground connection 11. The current-measuring device delivers a measurement signal i', corresponding to the current "i", to the signal-processing member SB.

In the case of an internal partial discharge, shown in the figure, the coil measures the current

$$i_z + (1-k) \cdot i$$

and for an external discharge or disturbance, the following current is measured

$$i_t + k \cdot i$$

It has been found that, with reasonable values of the constant k, the above-mentioned disadvantage of the device in Figure 2 may be eliminated. Preferably, k is chosen such that $0.1 \leq k \leq 0.5$. A lower value of k gives higher sensitivity to internal discharges and lower sensitivity to external discharges and disturbances, and is therefore preferable from these points of view. To obtain a simple calibration of the device, however, it may be advantageous to choose k = 0.5, which - if $i_z$ and $i_t$ are small compared with "i" - gives approximately the same sensitivity to internal and external discharges.

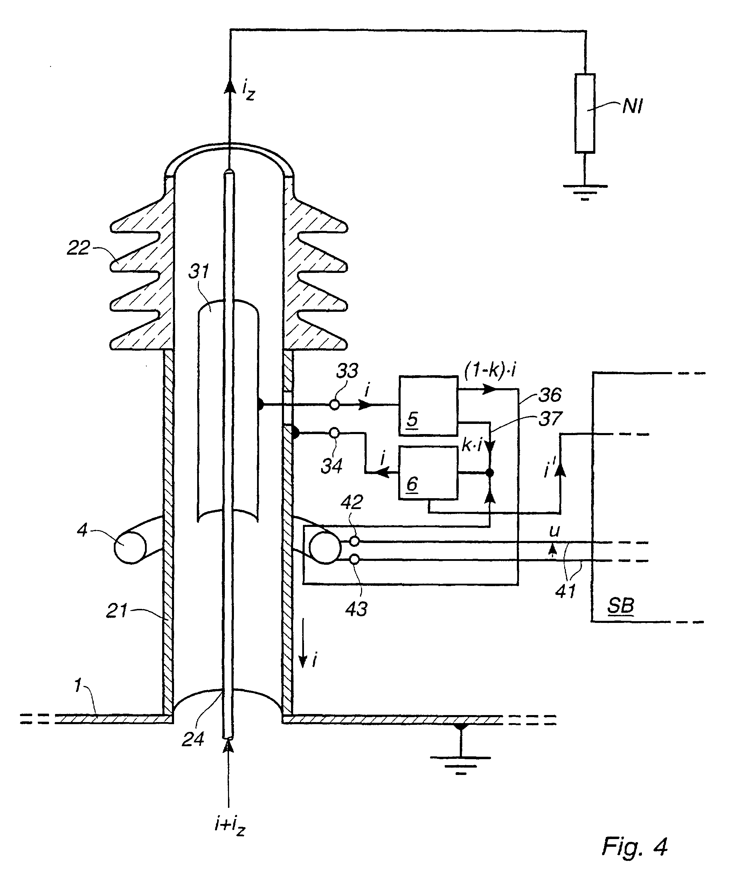

Normally, a power transformer has no ground connection which corresponds to the connection 11 in Figures 2 and 3, and in practice it is mostly difficult or unsuitable to arrange such a connection especially for the monitoring device according to the invention. However, a capacitive test tap normally has two connection terminals, one of which is connected to ground. For practical reasons, therefore, it is often desirable to use this ground terminal for ground connection of the monitoring device. Such an embodiment of the device is shown in Figure 4 (also this figure only shows the case of an internal partial discharge). The conductor 36 is there extended upwards through the measuring coil and is coupled to the ground terminal 34 of the test tap via the current measuring device 6. The function is the same as that described with reference to Figure 3, since the current $(1-k) \cdot i$ flowing upwards through the coil in the figure gives rise to an equal current flowing downwards through the pipe 21 and thus does not cause any net addition to the total current through the measuring coil.

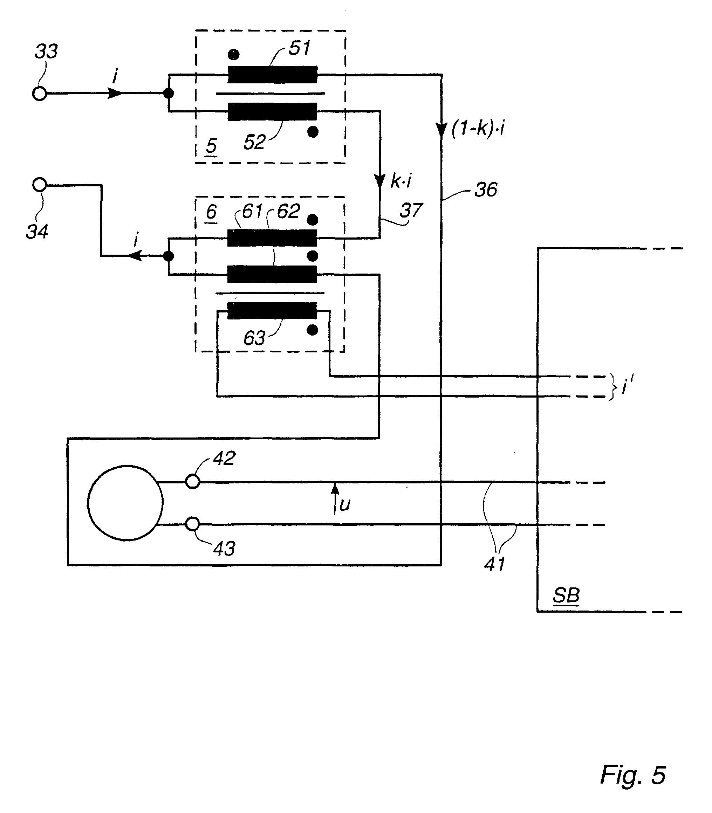

Figure 5 shows how the circuits, connected to the capacitive test tap, are designed in a preferred embodiment of the invention, wherein both the current-distributing member 5 and the current-measuring member 6 are constituted by current transformers. The current transformer 5 has two windings 51 and 52. With the chosen winding polarities, a current "i" from the test tap will be distributed between the conductors 36 and 37 with the proportion (1-k) i through the conductor 36 and the proportion k·1 through the conductor 37. The ratio between the number of turns of the windings determines the constant k, and, for example in case of equal number of turns of windings, k = 0.5.

The current transformer 6 has two primary windings, 61 and 62, coupled into the current paths 36 and 37. The secondary winding 63 of the transformer is coupled to the input stage of the signal-processing membes SB and delivers thereto a measurement signal i' corresponding to the sum of the currents in the conductors 36 and 37, that is, to the current "i".

This embodiment has several advantages. The current transformer 6 can be simply designed with the same impedance as the measuring coil. The two measurement signals will then have the same frequency and phase characteristic, which means that the two input circuits in the signal-processing members may be designed identical and that the need of individual adjustment during installation is eliminated. Further, the signal-processing members through the current transformer are galvanically separated from the bushing, which entails a reduced sensitivity to disturbances and overvoltages. An additional advantage is that the capacitive test tap (33) becomes grounded (through the conductors 36, 37 and the current transformers) in a relatively direct and interruption-safe manner, which minimizes the risk of interruptions, which would otherwise damage the bushing.

The embodiments of a device according to the invention described above are only examples, and such a device may be designed in a large number of other ways within the scope of the invention.

Thus, the invention has been described above in connection to its use in a power transformer. However, a device according to the invention may be used for monitoring partial discharges in other high-voltage equipment or apparatus, for example in gas-insulated switchgear equipment.

In the examples described above, the invention has been described in connection with a certain type of bushing, but it may, of course, be applied to other types of bushings as well. Also, the measuring coil, which in the examples described is placed between the capacitive test tap and the apparatus (the transformer), may, within the scope of the invention, be alternatively placed on the other side of the test tap (above this in the figures).

The embodiments shown in Figures 3 and 4 have current-measuring devices (6), the output signals (i') of which are supplied to the signal-processing members. Alternatively, however, the current "i" of the test tap may also in these embodiments be passed directly to the input stages of the signal-processing members in the manner shown in Figures 1 and 2.

**Claims**

1. A device for monitoring partial discharges in an electric high-voltage apparatus or high-voltage equipment, such as a high-voltage transformer (1), which apparatus has a high-voltage bushing (2) with a capacitive test tap (31-33), and which device comprises an inductive curent transducer in the form of a measuring coil (4) arranged around the high-voltage bushing, as well as signal-processing members (SB) adapted, for detection of partial discharges, to be supplied with measurement signals from the inductive current generator (u) and from the capacitive test tap (i, i'), wherein the device comprises a first current path (36) which is connected to the capacitive test tap and arranged outside the coil and which is arranged so as to form, together with the conductor (24) of the high-voltage bushing, a current loop around the coil for signals coming from inside the apparatus and originating from partial discharges.

2. A device according to claim 1, wherein it comprises a second current path (37) traversing the coil as well as current-distributing members (5) adapted to distribute a current (i) flowing from the capacitive test tap between the first (36) and second (37) current paths.

3. A device according to claim 2, wherein the current-distributing member (5) is in the form of a current transformer with a first winding (51) coupled into the first current path (36) and a second winding (52) coupled into the second current path (37).

4. A device according to any of claims claims 2 and 3, wherein the current-distributing member (5) is adapted to distribute the current from the capacitive test tap between the current paths such that a current (1-k)·i passes through the first current path and a current k·i passes through the second current path, wherein
   i is the current from the capacitive test tap
   k is a constant in the interval $0.1 \leq k \leq 0.5$.

5. A device according to any of the preceding claims, wherein a current transformer (6) is arranged for measurement of a current (i) flowing from the capacitive test tap and that the output signal (i') of the current transformer is adapted to be supplied to the signal-processing members (SB).

6. A device according to claim 5, wherein the current transformer (6) is designed such that, in relation to the signal-processing members (SB), it exhibits substantially the same impedance as the measuring coil (4).

7. A device according to any of the preceding claims in an apparatus, the high-voltage bushing of which has a capacitive test tap with two connection terminals (33, 34), one of which (34) constitutes a ground connection, wherein the current path or paths (36, 37) coupled to the capacitive test tap is/are coupled between the two connection terminals (33, 34) of the capacitive test tap.

8. A device according to any of the preceding claims, wherein the measuring coil (4) is a Rogowski coil.

**Patentansprüche**

1. Vorrichtung zum Überwachen partieller Entladungen in einer elektrischen Hochspannungseinrichtung oder einer Hochspannungsausrüstung so wie einem Hochspannungs-Wandler bzw. -Transformator (1), wobei die Vorrichtung eine Hochspannungsdurchführung (2) mit einem kapazitiven Prüfanschluss (31-33) aufweist, und wobei die Vorrichtung einen induktiven Strom-Messwandler in der Form einer Messspule (4) umfasst, die um die Hochspannungsbuchse angeordnet ist, ebenso wie signalverarbeitende Elemente (SB), die angepasst sind für die Erfassung von partiellen Entladungen, um mit Messsignalen von dem induktiven Stromgenerator (u) und von dem kapazitiven Prüfanschluss (i, i') versorgt zu werden, wobei die Vorrichtung einen ersten Strompfad (36) aufweist, der mit dem kapazitiven Prüfanschluss verbunden und außerhalb der Spule angeordnet ist, und der angeordnet ist, um zusammen mit dem Leiter (24) der Hochspannungsdurchführung eine Stromschleife um die Spule für Signale zu bilden, die von innerhalb der Einrichtung stammen und aus partiellen Entladungen herrühren.

2. Vorrichtung gemäß Anspruch 1, wobei sie einen zweiten Strompfad (37) aufweist, der die Spule durchläuft, ebenso wie stromverteilende Elemente (5), die angepasst sind, einen Strom (i) zu verteilen, der von dem kapazitiven Prüfanschluss zwischen dem ersten (36) und dem zweiten (37) Strompfad fließt.

3. Vorrichtung gemäß Anspruch 2, wobei das stromverteilende Element (5) in der Form eines Stromtransformators mit einer ersten Windung (51), die in den ersten Strompfad (36) eingekoppelt ist, und einer zweiten Windung (52), die in den zweiten Strompfad (37) eingekoppelt ist, vorliegt.

4. Vorrichtung gemäß irgendeinem der Ansprüche 2 und 3, wobei das stromverteilende Element (5) angepasst ist, den Strom von dem kapazitiven Prüfanschluss zwischen den Strompfaden zu verteilen, so dass ein Strom $(1-k) \cdot i$ durch den ersten Strompfad fließt, und ein Strom $k \cdot i$ durch den zweiten Strompfad fließt, wobei
i der Strom von dem kapazitiven Prüfanschluss ist; und
k eine Konstante in dem Intervall $0,1 \leq k \leq 0,5$ ist.

5. Vorrichtung gemäß irgendeinem der vorhergehenden Ansprüche, wobei ein Stromtransformator (6) für die Messung eines Stroms (i) angeordnet ist, der von dem kapazitiven Prüfanschluss fließt, und wobei das Ausgangssignal (i') des Stromtransformators angepasst ist, um den signalverarbeitenden Elementen (SB) zugeführt zu werden.

6. Vorrichtung gemäß Anspruch 5, wobei der Stromtransformator (6) so ausgelegt ist, dass er im Vergleich zu den signalverarbeitenden Elementen (SB) im Wesentlichen die gleiche Impedanz zeigt wie die Messspule (4).

7. Vorrichtung gemäß irgendeinem der vorhergehenden Ansprüche in einer Einrichtung, deren Hochspannungsdurchführung einen kapazitiven Prüfanschluss mit zwei Verbindungsanschlüssen (33, 34) aufweist, von denen einer (34) eine Masseverbindung darstellt, wobei der Strompfad oder die Strompfade (36, 37), der/die mit dem kapazitiven Prüfanschluss gekoppelt ist/sind, zwischen die zwei Verbindungsanschlüsse (33, 34) des kapazitiven Prüfanschlusses gekoppelt ist/sind.

8. Vorrichtung gemäß irgendeinem der vorhergehenden Ansprüche, wobei die Messspule (4) eine Rogowski-Spule ist.

**Revendications**

1. Dispositif pour surveiller des décharges partielles dans un appareil électrique à haute tension ou un équipement électrique à haute tension, tel qu'un transformateur (1) à haute tension, appareil qui a une traversée (2) à haute tension ayant une prise (31 - 33) de test capacitif, et ce dispositif comporte un transducteur de courant inductif sous la forme d'une bobine (4) de mesure disposée autour de la traversée à haute tension, ainsi que des éléments (SB) de traitement du signal conçus, pour la détection de décharges partielles, pour être alimentés en signaux de mesure en provenance du générateur (u) de courant inductif et de la prise (i, i') de test capacitif, dans lequel le dispositif comporte un premier trajet (36) de courant qui est relié à la prise de test capacitif et disposé à l'extérieur de la bobine et qui est disposé de manière à former, ensemble avec le conducteur (24) de la traversée à haute tension, une boucle de courant autour de la bobine pour des signaux provenant de l'intérieur de l'appareil et ayant pour origine des décharges partielles.

2. Dispositif suivant la revendication 1, dans lequel il comporte un deuxième trajet (37) de courant traversant la bobine ainsi que des éléments (5) de répartition du courant conçus pour répartir un courant (i) issu de la prise de test capacitif entre le premier trajet (36) et le deuxième trajet (37) de courant.

3. Dispositif suivant la revendication 2, dans lequel l'élément (5) répartiteur de courant est sous la forme d'un transformateur de courant ayant un premier enroulement (51) couplé dans le premier trajet (36) de courant et un deuxième enroulement (52) couplé dans le deuxième trajet (37) de courant.

4. Dispositif suivant l'une quelconque des revendications 2 et 3, dans lequel l'élément (5) répartiteur de courant est conçu pour répartir le courant à partir de la prise de test capacitif entre les trajets de courant, de sorte qu'un courant $(1-k) \cdot i$ passe par le premier trajet de courant et un courant $k \cdot i$ passe par le deuxième trajet de courant, dans lequel

i est le courant provenant de la prise de test capacitif,

k est une constante dans l'intervalle $0,1 \leq k \leq 0,5$.

5. Dispositif suivant l'une quelconque des revendications précédentes, dans lequel un transformateur (6) de courant est disposé pour la mesure d'un courant (i) en provenant de la prise de test capacitif et le signal (i') de sortie du transformateur de courant est conçu pour être fourni aux éléments (SB) de traitement de signal.

6. Dispositif suivant la revendication 5, dans lequel le transformateur (6) de courant est conçu de sorte que, en relation avec les éléments (SB) de traitement de signal, il présente sensiblement la même impédance que la bobine (4) de mesure.

7. Dispositif suivant l'une quelconque des revendications précédentes dans un appareil, la traversée à haute tension de cet appareil ayant une prise de test capacitif ayant deux bornes (33, 34) de connexion, dont l'une (34) constitue une connexion à la terre, le ou les trajets (36, 37) de courant, couplé(s) à la prise de test capacitif, est/sont couplé(s) entre les deux bornes (33, 34) de connexion de la prise de test capacitif.

8. Dispositif suivant l'une quelconque des revendications précédentes, dans lequel la bobine (4) de mesure est une bobine Rogowski.

*Fig. 1a*

*Fig. 1b*

Fig. 1c

*Fig. 2*

*Fig. 3*

Fig. 4

Fig. 5